# EUROPEAN PATENT SPECIFICATION

(11) **EP 1 181 579 B1**
(45) Date of publication and mention of the grant of the patent: **26.12.2007**
(21) Application number: 00915678.7
(22) Date of filing: 10.03.2000
(51) Int. Cl.: G01T 1/24, H01L 31/115

(54) **APPARATUS FOR DETECTING X-RAYS AND USE OF SUCH AN APPARATUS**
VORRICHTUNG ZUR RÖNTGENSTRAHLUNGSDETEKTION UND VERWENDUNG DER VORRICHTUNG
APPAREIL DE DETECTION DE RAYONS X ET UTILISATION DE CELUI-CI

(30) Priority: 10.03.1999 SE 9900856
(43) Date of publication of application: 27.02.2002
(73) Proprietor: Sectra Mamea AB, 164 40 Kista (SE)
(72) Inventor: DANIELSSON, Mats, S-182 43 Täby (SE)
(74) Representative: Egeröd, Lisbeth
(86) International application number: PCT/SE2000/000488
(87) International publication number: WO 2000/054072

(56) References cited:
- DE-C1- 19 618 465
- US-A- 4 937 453
- US-A- 5 227 635
- US-A- 5 847 398
- PATENT ABSTRACTS OF JAPAN & JP 63 117 286 A (MATSUSHITA ELECTRIC IND CO LTD) 21 May 1988
- DATABASE WPI Week 199316, Derwent Publications Ltd., London, GB; AN 1993-131747, XP002956034 & JP 5 072 150 A (HITACHI LTD) 23 March 1993 & PATENT ABSTRACTS OF JAPAN & JP 05 072 150 A (HITACHI LTD) 23 March 1993
- PATENT ABSTRACTS OF JAPAN & JP 59 099 384 A (SHIMAZU SEISAKUSHO KK) 05 June 1984

## Description

### Technical field

The present invention relates to a method for detecting x-rays as described in the preamble of claim 1. The invention also relates to an apparatus as described in the preamble of claim 5 and a use of such apparatus as described in the preamble of claim 16.

### Background to the invention

In medical x-ray imaging the central problem is to achieve the best possible image at the lowest possible radiation dose. To achieve this, high detection efficiency for all x-ray photons passing through the patient is crucial. Current x-ray imaging systems work with Detection Quantum Efficiencies (DQE) ranging from 10% to around 60%.

Silicon is in many ways the ideal detector material. The main advantages are the high quality and purity of the crystal combined with very low cost as a result of research and development in the semiconductor industry and the large volumes of silicon used in this field.

The main disadvantage with silicon is its low atomic number and corresponding decrease in stopping power for higher energy x-rays. A silicon detector wafer can only be made with a maximum thickness of around 1mm, and the standard thickness is about half of that. Thicker detectors will need application of prohibitively high voltages to deplete the whole detector volume to become an efficient x-ray detector. If the x-rays are incident at right angle to the surface this correspond to an efficiency of only 25% at 20keV.

A way around this problem is to orient the detector edge-on to the incident beam. In this geometry, the thickness of the silicon stopping the x-rays could be large enough to stop virtually all incident x-rays. This method is outlined in the invention described in US patent 4,937,453 by Robert S. Nelson. Edge-on detectors for increased efficiency is also conceivable for other semiconductor detectors but is particular important in the case of silicon because of the limited stopping power for this material due to its lightness.

A problem not anticipated in the method and device described in Nelson's patent (US 4,937,453) is that the semiconductor detector is always mechanically damaged in a zone close to the edge when it is cut. The cutting is usually performed with a diamond saw or a laser. In this area a large amount of background current is generated and the active sensors in the semiconductor wafer has to be put some distance from the edge in order not to be saturated by this background current, which would mask the signal from the x-rays. Usually, but not always, one or several guard-rings are placed between the active sensors (at least one sensor) and (at least one of) the edge(s) to sink the current generated at the edge of the detector and thus preventing it from reaching the active sensors. The distance between the edge and the active sensors are from 0.1mm to 0.6mm and the x-rays stopping in this region will not be detected. This, so called dead area, is equivalent to an inefficiency of the order of 20% in diagnostic x-ray imaging, such as mammography.

The loss of information is even more serious since predominantly the low energy photons that carry the most contrast information to the image will stop in the region close to the edge, which is not an active detector volume, and mainly the high energy photons, with less contrast information, will penetrate further down into the detector.

According to DE 19 61 84 65, a detector array has a number of detectors, each provided by a semiconductor plate of a directly converging semiconductor material with an electrode layer on two opposing sides. At least two detectors lie adjacent one another vertical to a surface receiving the incident radiation, with the main surfaces of the detectors set at an angle of between zero and 90 degrees to the latter surface. Separators of a radiation absorbing material are inserted between the detectors. The fundamental idea is to extend the length of the path of the incident radiation to the semiconductor detectors without increasing the distance between the electrodes. Moreover, the detector arrangement is intended for high energy radiation and is provided to detect Compton radiation.

JP 50732150 provides an arrangement to reduce manufacturing cost and improve SN, measurement precision, and using performance. An X-ray inspecting device is equipped with an X-ray source for irradiating X rays onto a sample in revolution, a collimator having slits formed in radial form, in order to draw the X-ray which permeate the sample is arranged; and a semiconductor detector for detecting the X-rays by a sensing part through the radiation of the X-ray beam from the slit is provided. Since the X-ray inspection device is installed in the angle other than a nearly right angle for the plane parallel to the vertical direction revolution axis center of the semiconductor inspection part and the sample and installed in inclination in an incidence angle for the extension line of the X-ray beam, the irradiation of the scattered X-ray due to the sample into the semiconductor detector is prevented, and the X-ray beam supplied from the slit can bc surely irradiated on the whole surface or a part of the sensing part. Also this arrangement is for high radiation applications.

### Summary of the invention

The object with the present invention is to provide a method for detecting x-rays which solves the above mentioned problems by providing a method according to claim 1.

Another object of the invention is to provide an apparatus for detecting x-rays according to claim 5 and a use of said apparatus according to claim 16.

An advantage with the present invention is that it enables a DQE close to 100% for energies of interest in diagnostic x-ray imaging ranging from 10keV to 50keV, combined with a high spatial resolution.

Another advantage is that the present invention is very simple and inexpensive to implement in a detector.

Another advantage is that the detector depth can be made large without having the x-rays passing the dead area close to the edge.

Another advantage is that the present invention improve the x-ray image and/or lower the radiation close for the patient.

### Brief description of drawings

Fig.1 shows the detector chip in perspective looking from the top. A guard ring is indicated together with the strips for the top contact for the individual diodes. The bond pads for each strip for connections to electronics are not indicated.
Fig. 2 shows the detector looking from the side together with incoming x-rays and a collimator defining the shape of the x-ray beam.

### Detailed description of the preferred embodiments

A silicon detector is fabricated from a raw silicon wafer that is exposed to different treatments to get the desired resistivity and other material parameters and the pattern of silicon strip sensors defining the individual pixels in the detector is fabricated through standard photolithographic techniques.

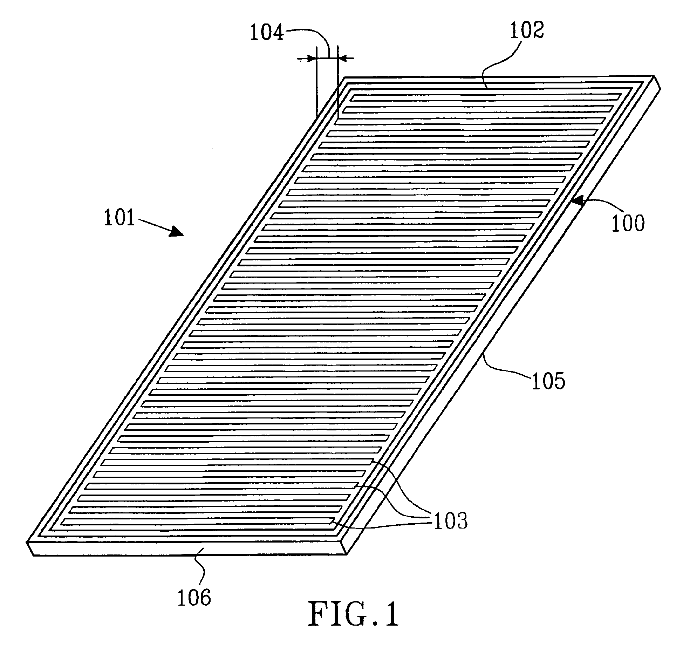

In Fig. 1 a detector chip 101 is displayed in a perspective view and a guard ring 102 is indicated together with individual pixel sensors 103 on a front side of the detector. The size of the pixel sensors is mainly determined by the demands on spatial resolution for a certain imaging task. In applications like mammography the distance between two adjacent pixels should be of the order 25 µm to 100 µm. The dead area 104 corresponds approximately to the distance from the edge of the detector to somewhere in between where the guard ring and where the strips start. The thickness of the wafers normally range from 300 µm to 500 µm. To deplete the whole volume of the detector a bias voltage is applied between the back of the detector 105, that is usually entirely covered with aluminum. The depletion can for example be achieved with +80V connected to the backside of the detector wafer. The pixel sensors can then be at ground and connected to electronics. In this case the holes created by the incident x-rays are collected by the electronics. With an inverse diode structure for the sensor pixels and -80V connected to the back of the detector the electrons would be collected by the electronics and this would work equally well. The bias voltage necessary to deplete the whole wafer is very dependent on the individual detector type and thickness and ranges from 10V to over 1000V.

The electronics, usually in terms of Application Specific Integrated Circuits, to collect and process the signals from the individual sensor pixels will be connected to the individual sensor pixels through standard interconnection techniques like wire bonding or bump bonding. The pads usually necessary for these interconnections are not indicated in Fig. 1 but should be situated close to the end 106 of the strips.

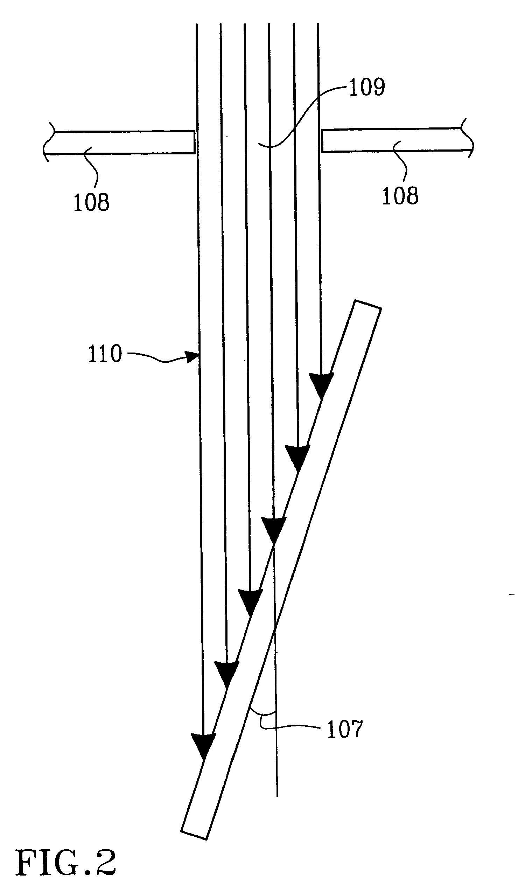

This invention suggest a geometry between the incident x-rays and the detector such that the inefficiency mentioned above disappears. Fig. 2 shows a detector that is slightly tilted with respect to the incident x-rays in order to make them hitting the detector at a small angle to the detector surface.

To achieve maximum detection efficiency, e.g. for mammography, the detector should be oriented relative to the incident x-rays according to Fig. 2. with a certain angle 107 between the detector surface and the x-rays. The collimator 108 will shape the x-ray beam to match the detector area (active area). By changing the angle of the incident x-rays relative to the surface of the detector the thickness of silicon that the x-ray will encounter is determined. The detection efficiency in turn is determined by the thickness of the silicon and the detection efficiency can thus be selected to meet requirements for a particular imaging task. If we assume a wafer thickness of 0.3mm and an x-ray energy of 25keV that is typical for mammography we will, with an angle of 2.8 degrees, achieve a detection efficiency in silicon exceeding 90 %. In this case, if the collimator slot 109 defining the shape of the incident x-rays has a width of 50 µm this would require an overall length of the detector of around 10mm. The incident x-rays will encounter around 7.5mm of silicon. A larger angle would mean slightly decreased detection efficiency but a shorter detector. Moreover, the dead are is excluded for the radiation.

For a 0.5mm detector thickness the same performance will be achieved with a slightly larger angle, around 3.8 degrees. Also fairly large angles of around 10 degrees results in as much as around 3mm depth of silicon for any incident x-rays in this case. This yields an efficiency that is high enough for several applications at lower energies, for 20 keV it would exceed 85%.

If the collimator is wider, e.g. 100 µm, the detector will have to be made longer in order to cover all the area under the collimator slot 109.

There is a choice weather to have the front side of the detector 101 in Fig. 1 or the back side of the detector 105 in Fig. 1 to face the incoming x-rays. Any of those schemes would work quite well but it is slightly advantageous to have the backside of the detector facing the x-rays. The reason for this is that the depletion zone, i.e. the active detector volume, does not extend all the way to the edge of the detector also in this direction, even if the dead area is much smaller, approximately of the order 1 µm, compared to the edge-on case. Since the extension of this dead area is less thick on the back side since less processing of the detector has taken place here it is advantageous to have the x-rays incident to the back side of the detector since this would yield a slightly increased efficiency.

In a system the x-ray imaging object will be placed between two collimator slots which are aligned with respect to each other and look more or less identical. The first collimator will shape the x-ray beam to match the active detector area. The second collimator slot will remove Compton scattered x-rays and the detector will be positioned after this collimator slot.

One important extension of the scheme above is to put several collimator slots and corresponding detectors after each other. This would increase image acquisition time since the area where x-rays are detected is increased. In Fig. 2 this would correspond to putting similar detectors and slots to the left and/or right of the indicated slot and detector. It may also be advisable to put an x-ray absorbing metal plate in between different detectors in this scheme to prevent scattered x-rays to reach adjacent detectors.

Other semiconductors than silicon, such as e.g. Gallium Arsenide or CdZnTe could be used in the scheme above instead of Silicon. They are however more expensive and difficult to work with and parameters like charge collection efficiency for the charge induced by the x-rays are not as good as for Silicon.

The invention is not limited the shown embodiments but can be varied in a number of ways without departing from the scope of the appended claims and the arrangement and the method can be implemented in various ways depending on application, functional units, needs and requirements etc.

## Claims

1. An apparatus for detection of incident radiation for radiographic imaging, for applications ranging from about 10 keV to 50 keV, the apparatus comprising:
• an X-ray detector (101) comprising a plurality of semiconductor X-ray strips (103) arranged on a substrate, said detector being of sufficient height to cause the dissipation of substantially all of the incident radiation within said detector,
• electrical outputs for each of the strips,
• electrical connections between each of the semiconductor X-ray strips such that an output corresponding to corresponding points in each of the strips is combined,
• said X-ray detector (101) being oriented relative to the incident radiation (110) such that an acute angle (107) is selected between a direction of said incident radiation and a side of said strip having said height such that said incident radiation mainly hit the side of said detector (101), said angle being less than ten (10) degrees,
**characterized in**
**that** said detector comprises at least one guard ring (102) extending on one side of said substrate and surrounding said semiconductor strip detectors and that said apparatus further comprises a collimator (108) to expose an active area on said radiation detector, whereby an area corresponding to a distance from the edge of the detector to a area between a guard ring and end of a semiconductor strip detector is excluded.

2. An apparatus according to claim 1, wherein said guard ring is arranged to sink leak current.

3. An apparatus according to claim 1, wherein said thickness of the detector is between about 0.1 mm and about 1.0 mm.

4. An apparatus according to claim 1, wherein said apparatus further comprises a collimator having a collimator slot for preventing the incident radiation from hitting the edge of the detector.

5. An apparatus according to claim 4, wherein said apparatus comprises several detectors, each having a collimator slot placed side by side.

6. An apparatus according to claim 5, further comprising an absorber placed between said detector for preventing scattering from one detector to another.

7. An apparatus according to claim 1, wherein said detector is made of silicon.

8. An apparatus according to claim 1, wherein said detector is made from the group consisting of gallium arsenide or CdZnTe.

9. An apparatus according to claim 1, wherein said incident radiation hits a backside of the detector.

10. Use of an apparatus for detection of incident radiation in scanned-slot medical imaging involving an apparatus according to claim 1.

11. Use of an apparatus for detecting incident radiation in scanned-slot medical imaging according to claim 10, wherein the use of said medical imaging is selected from the group consisting of mammography, bone densitometry and non-destructive testing.

## Patentansprüche

1. Vorrichtung zur Detektion einfallender Strahlung für die radiografische Bildgebung, für Anwendungen im Bereich von ca. 10 keV bis 50 keV, wobei die Vorrichtung aufweist:
- einen Röntgenstrahlendetektor (101), der eine Vielzahl von auf einem Substrat angeordneten Röntgen-Halbleiterstreifen (103) aufweist, wobei der Detektor ausreichend Höhe aufweist, um die Dissipation von im Wesentlichen der gesamten einfallenden Strahlung innerhalb des Detektors zu bewirken,
- elektrische Ausgänge für jeden der Streifen,
- elektrische Verbindungen zwischen den einzelnen Röntgen-Halbleiterstreifen in der Weise, dass ein Ausgang, der sich entsprechenden Punkten in jedem der Streifen entspricht, kombiniert wird,
- wobei der Röntgenstrahlendetektor (101) relativ zu der einfallenden Strahlung (110) in der Weise ausgerichtet ist, dass ein spitzer Winkel (107) zwischen einer Richtung der einfallenden Strahlung und einer Seite des Streifens, welcher die genannte Höhe aufweist, so gewählt ist, dass die einfallende Strahlung hauptsächlich die Seite des Detektors (101) trifft, wobei der Winkel weniger als zehn (10) Grad beträgt,
**dadurch gekennzeichnet, dass**
der Detektor wenigstens einen Schutzring (102) umfasst, welcher sich an einer Seite des Substrates erstreckt und die Halbleiterstreifendetektoren umgibt, und dass die Vorrichtung weiterhin einen Kollimator (108) aufweist, um einen aktiven Bereich auf dem Strahlungsdetektor zu exponieren, wodurch ein Bereich ausgenommen wird, welcher einem Abstand von dem Rand des Detektors zu einem Bereich zwischen dem Schutzring und einem Ende eines Halbleiterstreifendetektors entspricht.

2. Vorrichtung gemäß Anspruch 1, wobei der Schutzring angeordnet ist, um Leckstrom abzuleiten.

3. Vorrichtung gemäß Anspruch 1, wobei die Dicke des Detektors zwischen ca. 0,1 mm und ca. 1,0 mm beträgt.

4. Vorrichtung gemäß Anspruch 1, wobei die Vorrichtung weiterhin einen Kollimator, welcher einen Kollimatorschlitz hat, aufweist, um zu verhindern, dass die einfallende Strahlung auf den Rand des Detektors auftrifft.

5. Vorrichtung gemäß Anspruch 4, wobei die Vorrichtung mehrere Detektoren mit jeweils einem Kollimatorschlitz nebeneinander angeordnet aufweist.

6. Vorrichtung gemäß Anspruch 5, weiterhin einen Absorber aufweisend, welcher zwischen den Detektoren angeordnet ist, um Streuung von einem Detektor zu einem anderen zu verhindern.

7. Vorrichtung gemäß Anspruch 1, wobei der Detektor aus Silizium besteht.

8. Vorrichtung gemäß Anspruch 1, wobei der Detektor aus der Gruppe hergestellt ist, welche aus Galliumarsenid oder CdZnTe besteht.

9. Vorrichtung gemäß Anspruch 1, wobei die einfallende Strahlung eine Rückseite des Detektors trifft.

10. Verwendung einer Vorrichtung zur Detektion einfallender Strahlung bei der medizinischen Schlitz-Scan-Bildgebung unter Einbezug einer Vorrichtung gemäß Anspruch 1.

11. Verwendung einer Vorrichtung zum Detektieren einfallender Strahlung bei der medizinischen Schlitz-Scan-Bildgebung gemäß Anspruch 10, wobei die Verwendung der medizinischen Bildgebung aus der Gruppe ausgewählt ist, welche aus Mammografie, Knochendensitometrie und zerstörungsfreier Prüfung besteht.

## Revendications

1. Appareil de détection du rayonnement incident pour les images radiographiques, pour des applications allant de 10 keV à 50 keV, l'appareil comprenant :
• un détecteur de rayons X (101) comprenant une pluralité de bandes semi-conductrices de rayons X (103) agencées sur un substrat, ledit détecteur étant d'une hauteur suffisante pour causer la dissipation de pratiquement ou sensiblement la totalité du rayonnement incident à l'intérieur dudit détecteur,
• des sorties électriques pour chacune des bandes,
• des connexions électriques entre chacune des bandes semi-conductrice de rayons X, de sorte qu'une sortie correspondant à des points correspondants dans chacune des bandes est combinée,
• ledit détecteur de rayons X (101) étant orienté par rapport au rayonnement incident (110), de telle sorte qu'un angle aigu (107) est sélectionné entre une direction dudit rayonnement incident et un côté de ladite bande ayant ladite hauteur de telle sorte que le rayonnement incident heurte principalement le côté dudit détecteur (101), ledit angle étant inférieur à dix (10) degrés,
**caractérisé en ce que**
ledit détecteur comprend au moins un anneau de garde (102) s'étendant sur un côté dudit substrat et entourant lesdits détecteurs à bande semi-conductrice, et **en ce que** ledit appareil comprend en outre un collimateur (108) pour exposer une zone active sur ledit détecteur de rayonnement, sachant qu'une zone correspondant à une distance allant du bord du détecteur à une zone entre un anneau de garde et l'extrémité d'un détecteur à bande semi-conductrice est exclue.

2. Appareil selon la revendication 1, dans lequel ledit anneau de garde est agencé de façon à faire baisser le courant de fuite.

3. Appareil selon la revendication 1, dans lequel ladite épaisseur du détecteur est comprisse entre environ 0,1 mm et environ 1,0 mm.

4. Appareil selon la revendication 1, dans lequel ledit appareil comprend en outre un collimateur ayant une fente de collimateur afin d'empêcher le rayonnement incident de heurter le bord du détecteur.

5. Appareil selon la revendication 4, dans lequel ledit appareil comprend plusieurs détecteurs, ayant chacun une fente de collimateur placée l'une à côté de l'autre.

6. Appareil selon la revendication 5, comprenant en outre un absorbeur placé entre ledit détecteur afin d'empêcher la diffusion d'un détecteur à un autre.

7. Appareil selon la revendication 1, dans lequel ledit détecteur est en silicium.

8. Appareil selon la revendication 1, dans lequel ledit détecteur est fait à partir du groupe consistant en de l'arséniure de gallium ou CdZnTe.

9. Appareil selon la revendication 1, dans lequel ledit rayonnement incident heurte l'arrière du détecteur.

10. Utilisation d'un appareil de détection du rayonnement incident dans l'imagerie médicale à balayage à fente impliquant un appareil selon la revendication 1.

11. Utilisation d'un appareil de détection du rayonnement incident dans l'imagerie médicale à balayage à fente selon la revendication 10, dans lequel l'utilisation de ladite imagerie médicale est sélectionnée parmi le groupe comprenant les mammographies, les ostéodensitométries et les essais non destructifs.
